# EUROPÄISCHE PATENTSCHRIFT

(11) **EP 0 585 263 B1**
(45) Veröffentlichungstag und Bekanntmachung des Hinweises auf die Patenterteilung: **26.08.1998**
(21) Anmeldenummer: 92909422.5
(22) Anmeldetag: 07.05.1992
(51) Int. Cl.: H01L 31/119, H01L 29/78

(54) **HALBLEITERDETEKTOR**
SEMICONDUCTOR DETECTOR
DETECTEUR SEMICONDUCTEUR

(30) Priorität: 07.05.1991 DE 4114821; 20.06.1991 DE 4120443
(43) Veröffentlichungstag der Anmeldung: 09.03.1994
(73) Patentinhaber: KEMMER, Josef, Dr., D-85764 Oberschleissheim (DE)
(72) Erfinder: KEMMER, Josef, Dr., D-85764 Oberschleissheim (DE)
(74) Vertreter: Münich, Wilhelm, Dr.
(86) Internationale Anmeldenummer: DE9200358
(87) Internationale Veröffentlichungsnummer: WO9220105

(56) Entgegenhaltungen:
- US-A- 3 877 057
- US-A- 4 028 719
- US-A- 4 837 607
- US-A- 4 896 201

## Beschreibung

### Technisches Gebiet

Die Erfindung betrifft einen Halbleiterdetektor mit einem vollständig oder teilweise verarmten Grundgebiet gemäß dem Oberbegriff des Patentanspruchs 1.

Derartige Halbleiterdetektoren werden zum Nachweis ionisierender Strahlung benutzt und erlauben das Auslesen sowohl von Majoritäts- als auch Minoritätsladungsträgern. Sie werden insbesondere in Form der sogenannten Streifendetektoren zur Positionsbestimmung von ionisierender Strahlung eingesetzt.

### Stand der Technik

Bekanntermaßen werden zum Nachweis ionisierender Strahlung u.a. klassische pin-Dioden benutzt. Wesentliches Merkmal dieser pin-Diode ist ein hochohmiger Halbleiterkörper aus n-Silizium, der mit einer passivierenden Oxidschicht versehen ist. Auf der vorderen Hauptoberfläche ist ein Fenster in der Passivierungsschicht geöffnet und in diesem Bereich eine hohe p-Dotierung vorgenommen worden. Auf der hinteren Hauptoberfläche befindet sich ebenfalls im Oberflächenbereich eine dünne leitfähige Schicht hoher n-Dotierung. Auf beiden Gebieten hoher Leitfähigkeit befinden sich Metallelektroden. Die hochdotierte p-Schicht erzeugt einen asymmetrischen pn-Übergang, dessen Raumladungszone sich in den niedrigdotierten Halbleiterkörper ausdehnt, wenn die Diode in Sperrichtung gepolt wird, d.h. wenn eine negative Spannung an der p-Seite angelegt wird. Die Raumladungszone kann zum Nachweis elektromagnetischer und partikulärer Strahlung benutzt werden. Eine hohe Dotierung der beiden Kontakte ist vorteilhaft, um den Diffusionsstrom der Diode zu begrenzen.

Ein Halbleiterdetektor dieser Art ist in der DE-A-37 15 674 bzw. der US-A-4,896,201 beschrieben. Durch die Integration der Auslesekapazitäten und der Vorwiderstände konnte eine Reduktion des Aufwandes für die externe elektronische Auslese erreicht werden, die den Einsatz dieser Detektoren in vielen Fällen erst möglich machte.

Diese bisher bekannten Detektoren erfordern einen hohen technischen Aufwand bei der Fabrikation, da mehrere Maskenschritte und Implantationen auf beiden Seiten des Halbleiterkörpers durchgeführt werden müssen. Insbesondere im Hinblick auf den Einsatz sehr großer Stückzahlen derartiger Detektoren in der Grundlagenforschung spielen fertigungstechnische Fragen zukünftig eine immer wichtigere Rolle.

### Darstellung der Erfindung

Der Erfindung liegt die Aufgabe zugrunde, einen Halbleiterdetektor gemäß dem Oberbegriff des Anspruchs 1 derart weiterzubilden, daß eine fertigungstechnische Vereinfachung bei gleichen oder ähnlichen elektrischen Eigenschaften erzielt werden kann.

Das Wesen der Erfindung besteht darin, die für den Aufbau einer Raumladungszone in einem Halbleiterkörper der ersten Leitfähigkeit erforderlichen Elektroden hoher Leitfähigkeit in beiden Oberflächenbereichen nicht durch Dotierung zu erzeugen, sondern durch die Schaffung von Akkumulationsschichten bzw. Inversionsschichten auf beiden Hauptoberflächen. Um die Raumladungszone in den Halbleiter-körper ausdehnen zu können, müssen leitende Verbindungen zwischen den Inversions- bzw. Akkumulationsschichten und externen Spannungsquellen über geeignete Kontakte geschaffen werden. Die Kontakte werden hochohmig durch eine extern steuerbare Widerstandsschicht zu Elektroden des gleichen Leitungstyps hergestellt und befinden sich auf einer einzigen der beiden Hauptoberflächen. Diese Elektroden stellen die alleinige galvanische Verbindung zur Außenwelt dar. Die Auskopplung der Signalladung erfolgt kapazitiv über die Akkumulations- bzw. Inversionsschicht an den äußeren Elektroden.

Ferner ist zur entscheidenden Kostenersparnis in der Herstellung des erfindungsgemäßen, positionsempfindlichen Halbleiterdetektors die Herstellung der Detektorstruktur in nur drei Maskenschritten realisierbar.

Die weitere Ausbildung der erfindungsgemäßen Lösung ist den Patentansprüchen zu entnehmen.

Besonders bemerkenswert an Struktur und Betriebsart des neuen Halbleiterdetektors ist, daß auf seiner Rückseite keinerlei Kontakte zum Halbleiterkörper selbst erforderlich sind (Merkmal 1c). Diese Seite weist lediglich eine Elektrodenstruktur auf dem Isolator auf. Damit ist ein besonders einfaches Herstellungsverfahren von doppelseitigen Streifendetektoren oder ähnlichen Elementen gefunden worden.

Ein weiteres Unterscheidungsmerkmal zu bekannten Streifendetektoren besteht darin, daß auf beiden Hauptoberflächen die leitfähigen Gebiete der Streifen durch Inversion bzw. Akkumulation von Ladungsträgern gebildet werden und daß diese völlig von Gebieten entgegengesetzter Leitfähigkeit umschlossen sind, die ebenfalls durch Akkumulation bzw. Inversion der Ladungsträger erzeugt werden.

Die einzigen technologisch dotierten Bereiche sind die Source S und Drain D Gebiete der Transistoren und ein Kontaktbereich B zum Halbleiterkörper. Diese Dotierungen können durch Ionenimplantation hergestellt werden. In einer besonders einfachen Ausführung kann auf die Dotierung des Kontaktes zum Halbleiterkörper verzichtet werden, so daß lediglich ein Dotierschritt (Source und Drain) erforderlich ist.

Der erfindungsgemäße Detektor weist eine ganze Reihe von Vorteilen gegenüber bekannten Detektoren ähnlicher Ausführung auf. Einer der wesentlichen Vorteile besteht darin, daß die Photolithographieschritte vereinfacht und ihre Anzahl reduziert werden kann. In gleicher Weise kann die Zahl der Dotierschritte zumindest stark eingeschränkt werden. Da die Dotierung in der Regel durch Ionenimplantation erfolgt und entsprechende Maskierschritte voraussetzt, erlaubt das neue Verfahren eine einfachere und kostengünstigere Fertigung bei höheren Ausbeuten. So ist es beispielsweise möglich, einen doppelseitigen Streifendetektor zu konzipieren, der aus einem passivierten Halbleiterkörper besteht, auf dessen zweiter Hauptoberfläche als einziger Technologieschritt Metallelektroden aufgebracht werden. Die Kontaktierung und Spannungszuführung zu den leitfähigen Bereichen erfolgt von der ersten Hauptoberfläche aus.

Ein weiterer Vorteil ist darin zu sehen, daß die äußeren Elektroden nicht notwendiger Weise auf dem Detektor selbst aufgebracht werden müssen, sondern sich auf einem getrennten Leiterbahn-Substrat, z.B. einer Mylarfolie befinden können, die lediglich gegen die Isolationsschicht des Halbleiterkörpers gepreßt wird. In einem derartigen externen Leiterbahn-Substrat lassen sich komplizierte Leiterbahnen in nötigenfalls mehreren Lagen leichter und kostengünstiger realisieren als auf dem Siliziumkörper selbst. In diesem Fall braucht die entsprechende Halbleiteroberfläche überhaupt nicht struktuiert zu werden. Unter gewissen Voraussetzungen ist es sogar möglich, auf die Isolierschichten auf dem Halbleiterkörper zu verzichten und diese in die äußere Elektrodenvorrichtung zu integrieren.

Eine derartige Anordnung ist insbesondere bei solchen Halbleitern vorteilhaft, die sich gar nicht oder nur sehr schwer passivieren oder dotieren lassen.

Die Elektrodenanordnung auf einem externen Leiterbahn-Substrat, z.B. einer dünnen Folie ermöglicht die Herstellung von Detektoren, die keinerlei Bondverbindungen auf dieser Seite benötigen. Damit läßt sich ein bisher unlösbares Problem beim Einsatz von Streifendetektoren in medizinischen Anwendungen, wo der direkte Kontakt zur Probe erforderlich ist, einfach lösen.

Diese Anordnung ist auch besonders vorteilhaft für die Herstellung sogenannter Pad- oder Pixeldetektoren, bei denen jedes Pixel bzw. Pad getrennt ausgelesen werden soll. Bei Benutzung des erfindungsgemäßen Verfahrens mit externem Leiterbahn-Substrat können sowohl die Padelektroden als auch die dazugehörende Elektronik direkt auf diesem integriert werden. Damit entfällt das Kontaktieren einer großen Anzahl von Pads auf dem Detektor selbst.

Ein weiterer Vorteil der Elektrodenanordnung auf einem externen Leiterbahn-Substrat besteht darin, daß Pinholes in der Isolationsschicht des Halbleiters nicht notwendigerweise Kurzschlüsse zwischen den Metallelektroden und der leitfähigen Schicht unter dem Oxid zur Folge haben. Solche Kurzschlüsse führen bei den nach dem Stand der Technik gefertigten Detektoren zum Versagen der kapazitiven Kopplung und damit zum Ausfall.

Ein zusätzlicher Nutzen der externen Elektrodenanordnung ist auch darin zu sehen, daß bei geeigneter Wahl des Leiterbahn-Substratmaterials, dieses als Absorber für einen bestimmten Wellenlängen- bzw. Energiebereich der einfallenden Strahlung dienen kann (Absorber, Filter).

### Kurze Beschreibung der Erfindung

Die Funktionsweise des erfindungsgemäßen Detektors soll nun anhand von Ausführungsbeispielen näher beschrieben werden, die zugehörigen Zeichnungen zeigen:
- Fig. 1: einen Querschnitt durch ein erstes Ausführungsbeispiel einer Löcher-Inversionsschicht und kapazitiver Auslese der Minoritätsträger (Löcher) sowie mit einer Elektronen-Akkumulationsschicht und kapazitiver Auslese der Majoritätsträger (Elektronen),
- Fig. 2: einen Querschnitt durch ein erstes Ausführungsbeispiel nach Fig. 1 mit schematischer Darstellung der Elektrodenanordnung auf der oberen Hauptoberfläche,
- Fig. 3: einen Querschnitt durch ein erstes Ausführungsbeispiel nach Fig. 1 mit schematischer Darstellung der Elektrodenanordnung auf der unteren Hauptoberfläche.
- Fig. 4: einen Querschnitt durch und eine Draufsicht auf ein weiteres Ausführungsbeispiel
- Fig. 5: einen Querschnitt durch und eine Draufsicht auf ein weiteres Ausführungsbeispiel
- Fig. 6: einen Querschnitt durch und eine Draufsicht auf ein weiteres Ausführungsbeispiel

### Darstellung von Ausführungsbeispielen

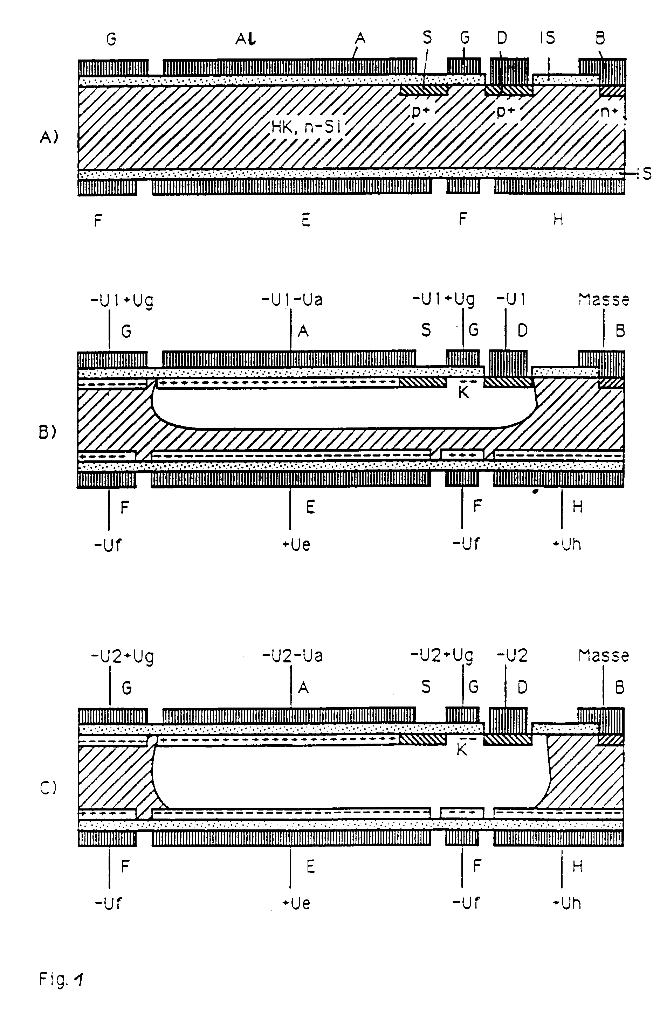

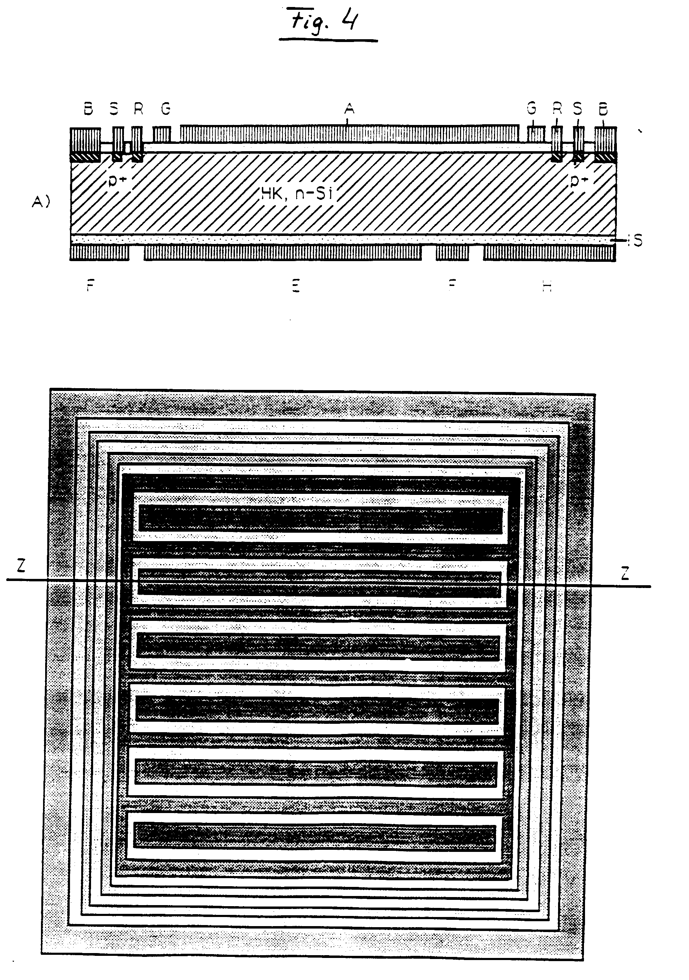

Fig. 1 bis Fig. 3 zeigen ein erstes Ausführungsbeispiel eines erfindungsgemäßen positionsempfindlichen Streifendetektors. Er besteht aus einem Array von streifenförmigen Metallelektroden auf beiden Hauptoberflächen, die gegeneinander elektrisch isoliert sind (Merkmale 1a und 1b des Anspruchs 1) und Elektrodenanordnungen für die Spannungsversorgung. Für die Figuren 4 bis 6 gilt das gleiche, gleichwohl sie verschiedene Kontakrmöglichkeiten auf den Hauptoberflächen zeigen.

Aus zeichnerischen Gründen sind die Streifensysteme auf den beiden Hauptoberflächen parallel zueinander angeordnet. Im praktischen Fall sind sie jedoch unter einem bestimmten Winkel, vorzugsweise um 90°, gegeneinander verdreht, um die Positionsbestimmung in beiden Koordinatenrichtungen zu ermöglichen.

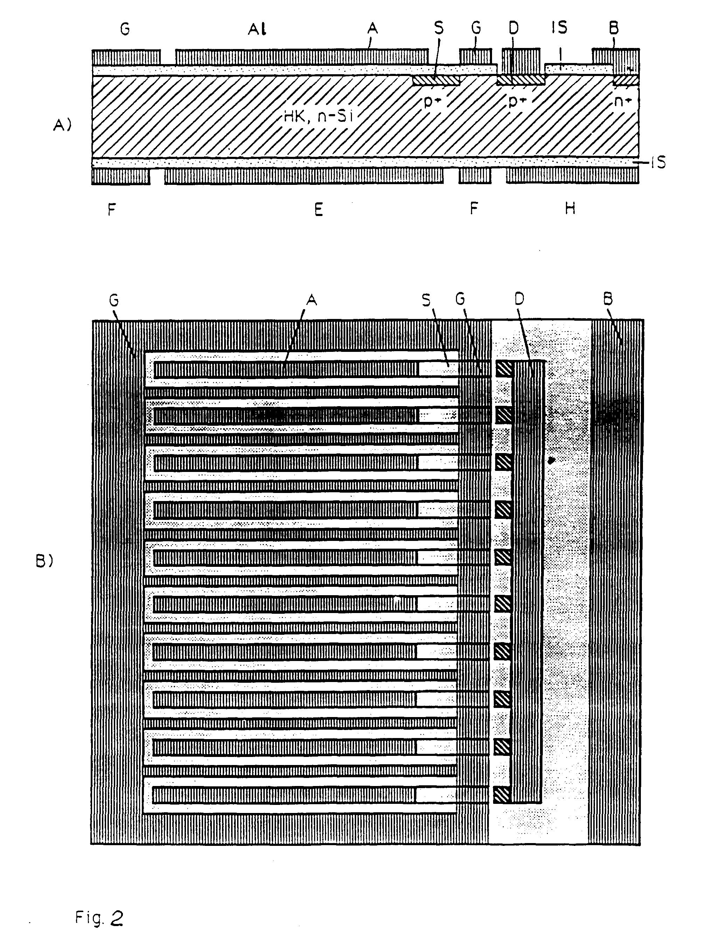

Die Querschnittsdarstellung in Fig. 1 A zeigt einen Schnitt durch die beiden Streifensysteme in Längsrichtung. Abgebildet ist ein Halbleiterkörper HK aus n-Silizium auf dessen beiden Hauptoberflächen sich eine ca. 20 nm (2000 A) dicke Isolationsschicht IS aus Siliziumoxid befindet. Darüber sind Metallelektroden aus Aluminium Al aufgebracht. Auf der oberen Hauptoberfläche befinden sich die Streifenelektrode A und an ihrer Stirnseite ein Transistor (Anspruch 14) mit den Gebieten S (Source), G (Gate) und D (Drain), der zur Spannungsversorgung der Inversionsschicht unter der Elektrode A dient. Umschlossen werden die Streifen A gemäß Merkmal 1b des Anspruchs 1 auf allen vier Seiten durch die Gateelektrode G (siehe Fig. 2 B). Daneben ist noch ein Kontakt B vorgesehen, der nach dem Merkmal 1c des Anspruchs 1 bzw. des Anspruchs 2 zum Kontaktieren des Halbleiterkörpers dient. Auf der Isolationsschicht der unteren Hauptoberfläche ist ein Metallkontakt E und das ihn umschließende Elektrodensystem F sowie eine Hilfselektrode H (Anspruch 13) aufgebracht.

Um den Detektor zu betreiben (Fig. 1 B) wird an die Streifenelektroden A eine kleine negative Spannung -Ua angelegt, die zu einer positiven Inversionsschicht unter dem Isolator an der Halbleiteroberfläche führt. Kontaktiert wird diese Inversionsschicht durch das Sourcegebiet S des danebenliegenden Transistors. Eine geringe positive Spannung +Ug an dem Elektrodensystem G (Transistorgate) isoliert die einzelnen Streifen hochohmig gegeneinander und stellt gleichzeitig über den Transistorkanal K und das Draingebiet D den Kontakt zu einer äußeren Spannungsquelle -U1 her (Merkmale 1a, b, c und Ansprüche 3, 4, 14).

Der Kontakt B gewährleistet die elektrische Verbindung zum Halbleiterkörper bzw. zur rückseitigen Hauptoberfläche und ist im Ausführungsbeispiel mit der Masse verbunden.

Wird nun eine zusätzliche negative Spannung -U1 (siehe Fig.1 B) an das Draingebiet D des Transistors, den Gatebereich G (-U1+Ug) und an die Streifenelektrode A (-U1-Ua) angelegt, so bildet sich eine Raumladungszone unter der Inversionsschicht der vorderen Hauptoberfläche aus, die sich mit zunehmender Spannung in den Halbleiterkörper ausdehnt. Der Detektor verhält sich also genau wie eine pin-Diode, deren Raumladungszone noch nicht bis zum Rückkontakt durchgreift. Ladungsträger, die durch ionisierende Strahlung im Volumen der Raumladungszone gebildet werden, werden durch das elektrische Feld getrennt. Die Löcher, die zur Vorderseite laufen, können kapazitiv über die Metallelektrode A ausgelesen werden (Anspruch la) und fließen über den Transistor zur Spannungsquelle -U1 (Merkmal 1c des Anspruchs 1, Ansprüche 3 und 14). Die Elektronen wandern durch den Halbleiterkörper zum Massekontakt B (Merkmal 1c und Anspruch 2).

Bei weiterer Erhöhung der Sperrspannung auf -U2 (siehe Fig.lC) kann der Detektor völlig verarmt werden und erlaubt auch das kapazitive Auskoppeln des Elektronensignals (Merkmal la). Dazu wird durch eine geringe positive Spannung +Ue an der Rückseitenelektrode eine leitende Akkumulationsschicht von Elektronen auf der unteren Hauptoberfläche generiert. Die Elektrode E wird vollständig von einer Schutzelektrode F umschlossen, die schwach negativ gepolt ist (-Uf) und eine hochohmige Verbindung zu einer weiteren äußeren Akkumulationsschicht unter der positiv gepolten Hilfselektrode H (+Uh) (Anspruch 13) darstellt. Die Breite der Hilfselektrode H ist so bemessen, daß die darunter liegende Akkumulationsschicht sich bis in den nicht verarmten Halbleiterkörper ausdehnt. Damit ist nach den Merkmalen 1b und 1c des Anspruchs 1 sowie Anspruch 2 eine leitende Verbindung zwischen dieser Schicht und der Masseelektrode B durch den Halbleiterkörper hindurch gewährleistet.

Eine Signalladung von Elektronen, die unter den beschriebenen Betriebsbedingungen zur Akkumulationsschicht unter der Elektrode E wandern, kann kapazitiv ausgelesen werden. Der Stromkreis der Elektronen ist von der Akkumulationsschicht unter E über die hochohmige Inversionsschicht der Elektrode F zur Akkumulationsschicht unter H und weiter über den Halbleiterkörper HK zum Massekontakt B geschlossen.

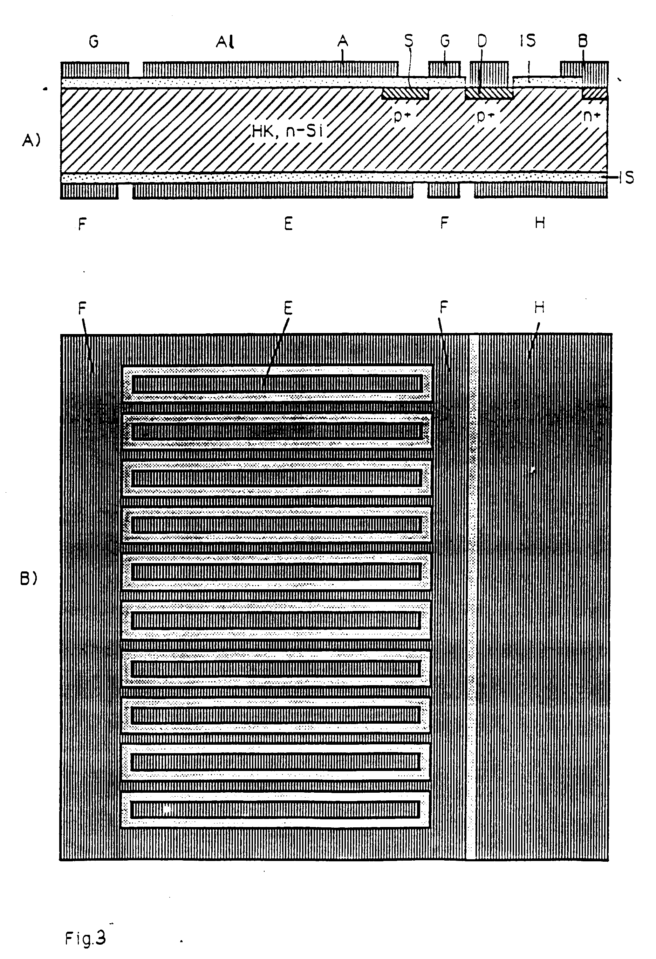

Die Fig. 2 und 3 zeigen das gleiche Ausführungsbeipiel mit einer schematischen Darstellung der Streifenkonfigurationen auf den beiden Hauptoberflächen. Des besseren Verständnisses halber sind die Source-, Gate- und Draingebiete der Transistoren vergrößert dargestellt. In der praktischen Ausführung genügt entgegen der Zeichnung ein kleinflächiger Kontakt zu dem implantierten Draingebiet.

Nach Anspruch 5 können die auf den Isolationsschichten des Halbleiterkörpers aufgebrachten Metallelektroden ganz oder teilweise durch ein entsprechend metallisiertes Kontakt-Substrat ersetzt werden. Für diese Ausführungsform eignet sich besonders nach den Fig. 1 bis 3 die untere Hauptoberfläche des Halbleiterkörpers. Das Kontakt-Substrat wird gegen die Oberfläche des Halbleiters gepreßt, wobei der Anpreßdruck durch die elektrostatischen Kräfte beim Anlegen der Potentiale an den Elektroden schon ausreichend hoch sein kann, um einen innigen Kontakt zur Isolatoroberfläche herzustellen. Gemäß Anspruch 9 sind auf diesem Substrat Teile der Ausleseelektronik integrierbar und es kann gleichzeitig nach Anspruch 10 und 11 als Schutz gegen Kontaminationen und Streulicht dienen.

Nach Anspruch 5, 6, 7, 9 bis 12, 16 und 17 lassen sich mit Hilfe eines oder mehrerer Kontakt-Substrate leicht Arrays oder Sandwichanordnungen von mehreren Detektoren konzipieren.

Die erfindungsgemäße Detektoranordnung unter Nutzung eines getrennten Kontakt-Substrates stellt eine wesentliche Vereinfachung dar, da die Elektronik zusammen mit den Leiterbahnen auf dem Kontakt-Substrat untergebracht werden kann. Bei Zerstörung des Halbleiterdetektors durch Strahlenschäden ist es möglich, die Kontakt-Substrate mit integrierter Elektronik wieder zu verwenden.

Bei der thermischen Oxidation von Silizium bildet sich immer eine positive Oxidladung aus, die bei n-Typ Silizium zu einer Elektronenakkumulationsschicht unter dem Oxid führt. Dieser Umstand kann im Ausführungsbeispiel nach Fig. 1 bis 3 dazu genutzt werden, auf die externen Spannungen (+Ue und +Uh) an den Elektrodengebieten E und H der unteren Hauptoberfläche zu verzichten. Damit ist für die untere Hauptoberfläche lediglich die Steuerspannung -Uf zum Einstellen des Serienwiderstandes zwischen den beiden Akkumulationsgebieten unter E und H erforderlich.

Positive Ladungen können z.B. auch durch die Behandlung von Oxidschichten in einem Gasplasma oder durch Behandlung mit UV Licht bzw. ionisierender Strahlung gebildet werden.

Die Querschnittsdarstellung in Fig. 4 A zeigt einen Schnitt durch die beiden Streifensysteme in Längsrichtung. Abgebildet ist ein Halbleiterkörper HK aus n-Silizium auf dessen beiden Hauptoberflächen sich eine ca. 200 nm (2000 A) dicke Isolationsschicht IS aus Siliziumoxid befindet. Darüber sind Metallelektroden aus Aluminium Al aufgebracht.

Es handelt sich hierbei um einen symmetrischen Aufbau, bei dem die Vorderseite des Halbleiterkörpers lokal mit p⁺-Implantation versehen ist.

Auf der oberen Hauptoberfläche befinden sich die Streifenelektrode A und an ihrer Stirnseite ein transistorähnlicher Elektrodenaufbau mit den Gebieten G (Gate), R und S sowie der Elektrode B. Hierbei ist der innere Elektrodenring R zur Spannungsversorgung der Inversionsschicht vorgesehen. Der sich daran anschließende Elektrodenring S - es können auch mehrere Ringe sein - dient als Guardring zum Abbau der Spannung. Der äußere Ring B stellt den Kontakt zur Masse her.

Der Abstand zwischen der Stirnseite der Streifenelektrode A zum Gate beträgt hierbei zwischen 3 und 10 µm, hingegen betragen die Abstände an den Längsseiten zwischen 20 und 200 µm.

Zwischen der, sich bei Anlegen einer negativen Spannung an der Streifenelektrode bildenden, Inversionsschicht unter dem Streifen und dem implantierten Ring R ist eine hochohmige Verbindung vorgesehen.

Die Metallelektroden wirken hierbei selbstjustierend, da sie in einem Maskenschritt herstellbar sind.

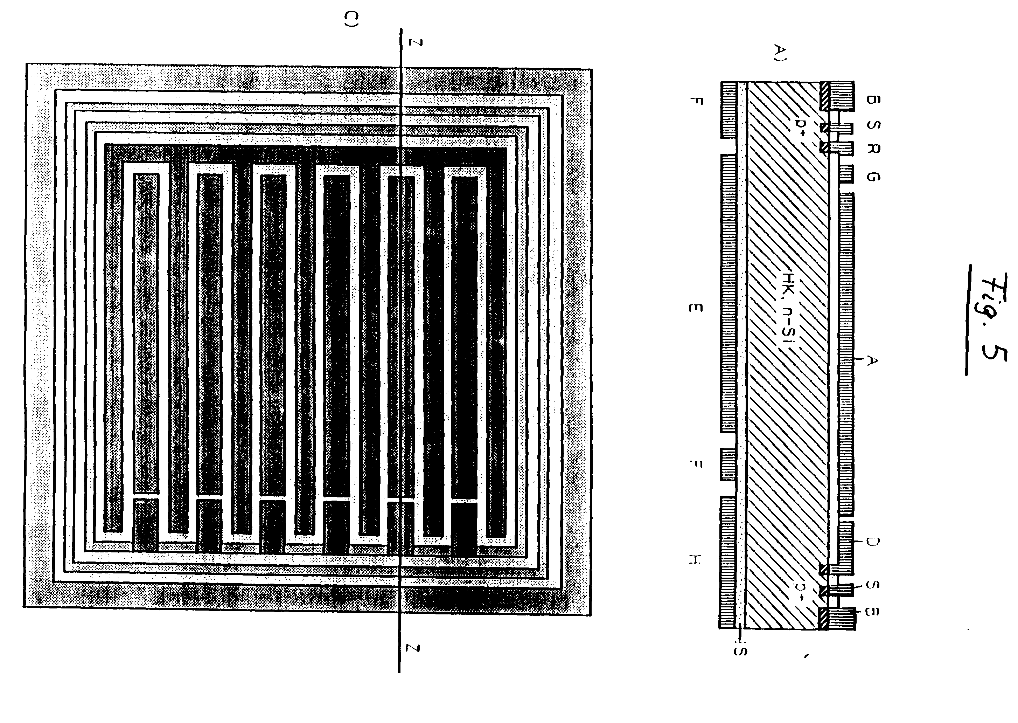

Figur 5 stellt einen asymmentrischen Aufbau eines Halbleiterdetektors vor, bei dem die Gateelektrode G die Streifen nicht vollständig umschließt.

Die Außenbereiche der Sensorstruktur sind mit der vorgenannten Ausführungsform identisch, jedoch sind hier zungenförmige Fielplates mit dem implantierten Ring S verbunden. Unter der normalen Betriebsspannung bildet sich unter den Zungen D eine Inversionsschicht aus, die den hochohmigen Kontakt zur Inversionsschicht der Streifen herstellt.

Auch hier wirken die metallelektroden selbstjustierend, da sie in einem einzigen Maskenschritt herstellbar sind.

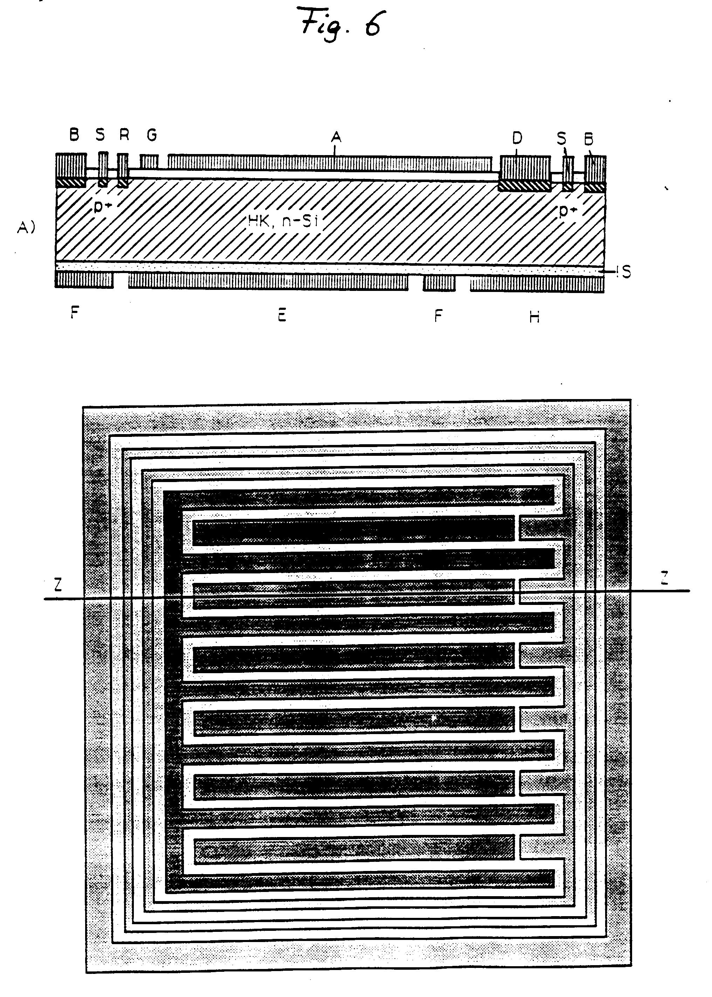

Im Ausführungsbeispiel der Figur 6 wird ein weiterer asymmetrischer Aufbau eines erfindungsgemäßen Halbleiterdetektors angegeben, dessen innerer Ring R auf einer Seite Zungen aufweist. Dabei wird der Kontakt zwischen der sich bildenden Inversionsschicht unter den Streifen und den Zungen über einen Oxidspalt von ca. 3 µm bewerkstelligt.

Vorstehend sind Ausführungsbeispiele ohne Beschränkung der Allgemeinheit beschrieben worden. Selbstverständlich sind im Rahmen des allgemeinen Erfindungsgedankens die verschiedensten Modifikationen möglich wie z.B. die Verwendung anderer Halbleitermaterialien, Isolatoren und Leiter. Insbesondere kann anstelle eines n-Typ Halbleiters auch sinngemäß ein p-Typ Halbleiter verwendet werden. Weiterhin ist es möglich Detektoren zu konzipieren, bei denen MIS Strukturen und technologisch dotierte Gebiete beider Leitfähigkeiten nebeneinander eingesetzt werden.

## Patentansprüche

1. Positionsempfindlicher Halbleiterdetektor mit einem vollständig verarmten Grundgebiet (HK) einer ersten Leitfähigkeit und Isolationsschichten (IS) auf beiden Hauptoberflächen sowie leitenden Elektroden (A, G, E, F, H) auf diesen Isolationsschichten, die MIS-Strukturen bilden,
**gekennzeichnet** durch folgende Merkmale:
a) die zur Verarmung des Grundgebietes der ersten Leitfähigkeit erforderlichen Gebiete der ersten und zweiten Leitfähigkeit auf beiden Hauptoberflächen werden durch die Ausbildung von Inversions- und Akkumulationsschichten, die im Oberflächenbereich des Grundgebietes an zwei gegenüberliegenden Hauptoberflächen angrenzen, im Oberflächenbereich unter leitenden Elektroden (A, E) die streifenförmig ausgebildet sind, an denen gleichzeitig die influenzierte Signalladung abgegriffen wird, erzeugt;
b) die zur Verarmung des Grundgebietes der ersten Leitfähigkeit erforderlichen Gebiete der ersten und zweiten Leitfähigkeit sind vollkommen von Gebieten entgegengesetzter Leitfähigkeit umschlossen, die durch Akkumulation und Inversion von Ladungsträgern gebildet werden und deren Leitfähigkeit über leitende Elektroden (G, F) gesteuert wird;
c) die externe Spannungszuführung zu den Gebieten der ersten und zweiten Leitfähigkeit des Halbleiterkörpers erfolgt von dotierten Gebieten (B, S, D) der ersten und zweiten Leitfähigkeit aus, die sich beide im Bereich einer der beiden Hauptoberflächen befinden, und mittels Elektroden (B, D) Kontaktiert sind.

2. Detektor nach Anspruch 1,
dadurch **gekennzeichnet**, daß nur eine Elektrode (B) für die externe Spannungszuführung zu den Gebieten der ersten Leitfähigkeit vorgesehen ist.

3. Detektor nach Anspruch 1 und 2,
dadurch **gekennzeichnet**, daß nur eine Elektrode (D) für die externe Spannungszuführung zu den Gebieten der zweiten Leitfähigkeit vorgesehen ist.

4. Detektor nach einem der Ansprüche 1 bis 3,
dadurch **gekennzeichnet**, daß die Isolationsschicht und die leitenden Elektroden eine Einheit mit dem Halbleitergrundkörper bilden (MIS-Struktur).

5. Detektor nach einem der Ansprüche 1 bis 3,
dadurch **gekennzeichnet**, daß die leitenden Elektroden auf einem getrennte, externen Leiterbahn-Substrat aufgebracht sind und dieses mit dem Halbleiterkörper, z.B. durch Pressen gegen die Isolationsschicht des Halbleiterkörpers, verbunden ist.

6. Detektor nach einem der Ansprüche 1 bis 3,
dadurch **gekennzeichnet**, daß sowohl die Isolationsschicht als auch die leitenden Elektroden der MIS-Struktur auf einem getrennten externen Leiterbahn-Substrat aufgebracht sind, welches mit dem Halbleiterkörper verbunden ist.

7. Detektor nach einem der Ansprüche 1 bis 6,
dadurch **gekennzeichnet**, daß die Isolationsschicht aus mehreren Lagen besteht.

8. Detektor nach einem der Ansprüche 1 bis 7,
dadurch **gekennzeichnet**, daß Inversions- und Akkumulationsschichten durch Ladungen in oder auf der Isolationsschicht erzeugt werden.

9. Detektor nach einem der Ansprüche 5 bis 8,
dadurch **gekennzeichnet**, daß das externe Leiterbahnsubstrat auch Teile der Elektronik enthält.

10. Detektor nach einem der Ansprüche 5 bis 7,
dadurch **gekennzeichnet**, daß das externe Leiterbahn-Substrat gleichzeitig als Schutz des Halbleiters gegen Kontamination dient.

11. Detektor nach einem der Ansprüche 5 bis 10
dadurch **gekennzeichnet**, daß das externe Leiterbahnsubstrat gleichzeitig ein Absorber für Strahlung definierter Wellenlänge bzw. Energie ist.

12. Detektor nach einem der Ansprüche 5 bis 11
dadurch **gekennzeichnet**, daß als externes Leiterbahn-Substrat ein zweiter Halbleiterkörper verwendet wird.

13. Detektor nach einem der Ansprüche 1 bis 12
dadurch **gekennzeichnet**, daß er als doppelseitiger Streifendetektor ausgeführt ist, wobei die Spannungszuführung zu den Streifen der ersten Leitfähigkeit hochohmig über eine MOS-Struktur und ein daneben liegendes Gebiet der ersten Leitfähigkeit erfolgt.

14. Detektor nach Anspruch 13,
dadurch **gekennzeichnet**, daß die Spannungszuführung zu den Streifen der zweiten Leitfähigkeit hochohmig über eine Transistor-Struktur erfolgt, wobei die Gebiete der Streifen die Sourcegebiete (s) der Transistoren enthalten.

15. Detektor nach Anspruch 13,
dadurch **gekennzeichnet**, daß bei streifenförmiger Anordnung der Metallelektroden bzw. der leitfähigen Kontakte auf beiden Hauptoberflächen des Detektors diese Elektroden oder Kontakte unter einem bestimmten Winkel, vorzugsweise um 90 Grad, gegeneinander verdreht sind.

16. Detektoranordnung mit mehreren positionsempfindlichen Halbleiterdetektoren nach einem der Ansprüche 1 bis 9,
dadurch **gekennzeichnet**, daß mehrere Einzeldetektoren gemeinsam auf ein äußeres Leiterbahn-Substrat aufgebracht sind.

17. Detektoranordnung mit mehreren positionsempfindlichen Halbleiterdetektoren nach einem der Ansprüche 1 bis 8 oder 10 bis 11,
dadurch **gekennzeichnet**, daß eine Sandwichanordnung in der Weise vorgesehen ist, daß sich zwischen zwei Lagen von Halbleitern ein gemeinsames externes Leiterbahn-Substrat befindet.

18. Verfahren zur Herstellung eines positionsempfindlichen Halbleiterdetektors nach Anspruch 8, dadurch **gekennzeichnet**,
daß die Ladungen in der Isolationsschicht durch elektromagnetische und/oder partikuläre Strahlung erzeugt werden.

19. Verfahren zur Herstellung eines Detektors nach Anspruch 8,
dadurch **gekennzeichnet**, daß Ladungen in der Isolationsschicht während des Herstellungsvorganges dieser Schicht erzeugt werden.

20. Verfahren zur Herstellung eines Positionsempfindlicher Halbleiterdetektors nach einem der Ansprüche 1 bis 15,
dadurch **gekennzeichnet**, daß die Herstellung der Detektorstruktur in drei Maskenschritten realisiert wird.

21. Verfahren nach Anspruch 20,
dadurch **gekennzeichnet**, daß der Halbleitersensor p⁺-dotierte Bereiche aufweist.

22. Verfahren nach Anspruch 20 oder 21,
dadurch **gekennzeichnet**, daß der Elektrodenaufbau symmetrisch ist.

23. Verfahren nach einem der Ansprüche 20 bis 22,
dadurch **gekennzeichnet**, daß der Elektrodenaufbau asymmetrisch ist.

## Claims

1. A position-sensitive semiconductor detector having a completely depleted primary area (HK) of a first conductivity and insulation layers (IS) on the two main surfaces as well as conducting electrodes (A,G,E,F,H) on said insulation layers, which form MIS structures,
**characterized** by the following features:
a) the areas of the first and second conductivity on said two main surfaces required for the depletion of said primary area of said first conductivity are generated by the development of inversion and accumulation zones, which in the surface area of the primary area are adjacent to the two main surfaces lying oppositie each other, in the surface area under said conducting electrodes (A,E), which are designed strip-shaped and from which the influenced signal charge is simultaneously tapped;
b) said areas of the first and second conductivity on said two main surfaces required for the depletion of said primary area of said first conductivity are completely enclosed by areas of the opposite conductivity, which are generated by accumulation and inversion of charge carriers and their conductivity is controlled via said conducting electrodes (G,F);
c) an external voltage supply to said areas of said first and second conductivity of the semiconductor body ensues from doped areas (E,S,D) of said first and second conductivity, which are both located in the area of one of said two main surfaces and contacted by means of electrodes (B,D).

2. A detector according to claim 1,
**characterized** in that only one electrode (B) is provided for the external voltage supply to said areas of said first conductivity.

3. A detector according to claim 1 and 2,
**characterized** in that only one electrode (D) is provided for the external voltage supply to said areas of said second conductivity.

4. A detector according to one of the claims 1 to 3,
**characterized** in that said insulation layer and said conducting electrodes form a unit with said semiconductor body (MIS structure).

5. A detector according to one of the claims 1 to 3,
**characterized** in that said conducting electrodes are disposed on a separate external conductor-strip substrate and the latter is connected to said semiconductor body, e.g. by means of pressing against said insulation layer of said semiconductor body.

6. A detector according to one of the claims 1 to 3,
**characterized** in that both said insulation layer and said conducting electrodes of said MIS structure are disposed on a separate external conductor-strip substrate, which is connected to said semiconductor body.

7. A detector according to one of the claims 1 to 6,
**characterized** in that said insulation layer is composed of several layers.

8. A detector according to one of the claims 1 to 7,
**characterized** in that inversion and accumulation zones are generated by charges in or on said insulation layer.

9. A detector according to one of the claims 5 to 8,
**characterized** in that said external conductor-strip substrate also contains components of the electronics.

10. A detector according to one of the claims 5 to 7,
**characterized** in that said external conductor-strip substrate simultaneously serves as protection against contamination for said semiconductor.

11. A detector according to one of the claims 5 to 10,
**characterized** in that said extertnal conductor-strip substrate is simultaneously an absorber for radiation of defined wavelength, respectively energy.

12. A detector according to one of the claims 5 to 11,
**characterized** in that a second semiconductor body is used as said external conductor-strip substrate.

13. A detector according to one of the claims 1 to 12,
**characterized** in that it is designed as a two-faced strip detector, with the voltage supply to the strips of the first conductivity occurs high-resistively via a MOS structure and an adjacent area of the first conductivity.

14. A detector according to claim 13,
**characterized** in that the voltgage supply to the strips of the second conductivity occurs high-resistively via a transistor structure, with the areas of said strips containing the source areas (S) of the transistors.

15. A detector according to claim 13,
**characterized** in that with the strip-shaped arrangement of the metal electrodes, respectively the conductive contacts on both main surfaces of said detector said electrodes or contacts are arranged at a specific angle, preferably at 90° to each other.

16. A detector arrangement having a multiplicity of position-sensitive semiconductor detectors according to one of the claims 1 to 15,
**characterized** in that a multiplicity of individual detectors are disposed together on an external conductor-strip substrate.

17. A detector arrangement having a multiplicity of position-sensitive semiconductor detectors according to one of the claims 1 to 8 or 10,
**characterized** in that a sandwich arrangement is provided in such a manner that a mutual external conductor-strip substrate is located between two layers of semiconductors.

18. A process for the fabrication of a position-sensitive semiconductor detector according to claim 8,
**characterized** in that the charges in said insulation layer are generated by means of electromagnetic or particle radiation.

19. A process for the fabrication of a detector according to claim 8,
**characterized** in that charges in said insulation layer are generated during the fabricationg process of said layer.

20. A process for the fabrication of a position-sensitive semiconductor detector according to one of the claims 1 to 15,
**characterized** in that the fabrication of the detector structure is realized in three masking steps.

21. A process according to claim 20,
**characterized** in that the semiconductor sensor has p⁺-doped areas.

22. A process according to claim 20 or 21,
**characterized** in that the arrangement of the electrodes is symmetrical.

23. A process according to one of the claims 20 to 22,
**characterized** in that said arrangement of the electrodes is asymmetrical.

## Revendications

1. Détecteur à semiconducteurs, sensible à une position, comportant une région de base (HK) complètement appauvrie possédant une première conductivité et des couches isolantes (IS) situées sur les deux surfaces principales, ainsi que des électrodes conductrices (A,G,E,F,H), qui forment des structures MIS, caractérisé par les caractéristiques suivantes :
a) les régions possédant les première et seconde conductivités, qui sont nécessaires pour appauvrir la région de base possédant la première conductivité et qui sont situées sur les deux surfaces principales, sont réalisées au moyen de la formation de couches d'inversion et d'accumulation, qui, dans la zone de la surface de la région de base, sont contiguës à deux surfaces principales opposées, dans la zone de la surface au-dessous d'électrodes conductrices (A,E), qui sont réalisées sous la forme de bandes et au niveau desquelles est prélevée simultanément la charge de signal influencée;
b) les régions possédant les première et seconde conductivités et qui sont nécessaires pour l'appauvrissement de la région de base possédant la première conductivité sont entourées complètement par des régions ayant une conductivité opposée et qui sont formées par accumulation et inversion de porteurs de charges et dont la conductivité est commandée par l'intermédiaire d'électrodes conductrices (G,F);
c) l'application extérieure d'une tension aux régions possédant les première et seconde conductivités du corps semiconducteur s'effectue à partir de régions dopées (E,S,D) possédant les première et seconde conductivités et qui sont situées toutes les deux au voisinage de l'une des deux surfaces principales et avec lesquelles un contact est établi au moyen d'électrodes (B,D).

2. Détecteur selon la revendication 1, caractérisé en ce qu'une seule électrode (B) est prévue pour l'application externe d'une tension aux régions possédant la première conductivité.

3. Détecteur selon les revendications 1 et 2, caractérisé en ce qu'une seule électrode (D) est prévue pour l'application externe d'une tension aux régions possédant la seconde conductivité.

4. Détecteur selon l'une des revendications 1 à 3, caractérisé en ce que la couche isolante et les électrodes conductrices forment une unité avec le corps de base semiconducteur (structure MIS).

5. Détecteur selon l'une des revendications 1 à 3, caractérisé en ce que les électrodes conductrices sont déposées sur un substrat extérieur commun portant des voies conductrices et que ce substrat est relié au corps semiconducteur, par exemple par serrage contre la couche isolante du corps semiconducteur.

6. Détecteur selon l'une des revendications 1 à 3, caractérisé en ce qu'aussi bien la couche isolante que les électrodes conductrices de la structure MIS sont déposées sur un substrat externe séparé portant les voies conductrices et qui est relié au corps semiconducteur.

7. Détecteur selon l'une des revendications 1 à 6, caractérisé en ce que la couche isolante est formée de plusieurs couches.

8. Détecteur selon l'une des revendications 1 à 7, caractérisé en ce que des couches d'inversion et d'accumulation sont produites par des charges dans ou sur la couche isolante.

9. Détecteur selon l'une des revendications 5 à 8, caractérisé en ce que le substrat externe portant les voies conductrices contient également des parties du circuit électronique.

10. Détecteur selon l'une des revendications 5 à 7, caractérisé en ce que le substrat externe portant les voies conductrices sert simultanément d'élément de protection du semiconducteur vis-à-vis d'une contamination.

11. Détecteur selon l'une des revendications 5 à 10, caractérisé en ce que le substrat externe portant les voies conductrice est simultanément un absorbeur pour le rayonnement ayant une longueur d'onde définie ou une énergie définie.

12. Détecteur selon l'une des revendications 5 à 11, caractérisé en ce qu'on utilise comme substrat externe portant les voies conductrices un second corps semiconducteur.

13. Détecteur selon l'une des revendications 1 à 12, caractérisé en ce qu'il est agencé sous la forme d'un détecteur double face, l'application de la tension aux bandes possédant la première conductivité s'effectuant selon une liaison à forte valeur ohmique par l'intermédiaire d'une structure MOS et d'une région juxtaposée à cette structure et possédant la première conductivité.

14. Détecteur selon la revendication 13, caractérisé en ce que l'application de tensions aux bandes possédant la seconde conductivité s'effectue selon une liaison à forte valeur ohmique par l'intermédiaire d'une structure de transistor, les régions des bandes contenant les régions de source (s) des transistors.

15. Détecteur selon la revendication 13, caractérisé en ce que dans le cas de la disposition sous la forme de bandes des électrodes métalliques ou des contacts conducteurs sur les deux surfaces principales du détecteur, ces électrodes de contact sont pivotées réciproquement sous un angle déterminé, de préférence 90 degrés.

16. Dispositif à détecteurs comportant plusieurs détecteurs à semiconducteurs, sensibles à une position, selon l'une des revendications 1 à 15, caractérisé en ce que plusieurs détecteurs individuels sont disposés en commun sur un substrat extérieur portant les voies conductrices.

17. Dispositif à détecteurs comportant plusieurs détecteurs à semiconducteurs, sensibles à une position, selon l'une des revendications 1 à 8 ou 10 à 16, caractérisé en ce qu'un dispositif sandwich est prévu de telle sorte qu'un substrat extérieur commun portant des voies conductrices est disposé entre deux couches de semiconducteurs.

18. Procédé pour fabriquer un détecteur à semiconducteurs sensible à une position selon la revendication 8, caractérisé en ce que les charges sont produites dans la couche isolante au moyen d'un rayonnement électrique et/ou particulaire.

19. Procédé pour fabriquer un détecteur selon la revendication 8, caractérisé en ce que les charges sont produites dans la couche isolante pendant le processus de fabrication de cette couche.

20. Procédé pour fabriquer un détecteur à semiconducteurs, sensible à une position, selon l'une des revendications 1 à 15, caractérisé en ce que la fabrication de la structure à détecteurs est réalisée en trois étapes de masquage.

21. Procédé selon la revendication 20, caractérisé en ce que le détecteur à semiconducteurs comporte des régions dopées de type p⁺.

22. Procédé selon la revendication 20 ou 21, caractérisé en ce que l'agencement des électrodes est symétrique.

23. Procédé selon l'une des revendications 20 à 22, caractérisé en ce que la construction des électrodes est dissymétrique.
